(19) Europäisches Patentamt
European Patent Office
Office européen des brevets

(11) **EP 3 575 004 B1**

(12) **EUROPEAN PATENT SPECIFICATION**

(45) Date of publication and mention of the grant of the patent:
**28.06.2023 Bulletin 2023/26**

(21) Application number: **18174756.9**

(22) Date of filing: **29.05.2018**

(51) International Patent Classification (IPC):
**B05D 1/18** (2006.01)   **C23C 18/16** (2006.01)
**C23C 18/18** (2006.01)   **B05D 7/14** (2006.01)

(52) Cooperative Patent Classification (CPC):
**B05D 1/185; C23C 18/166; C23C 18/1834; C23C 18/1882;** B05D 7/14; B05D 2202/00; B05D 2401/20

(54) **REDOX ATOMIC LAYER DEPOSITION**

REDOX-ATOMLAGENABSCHEIDUNG

DÉPÔT DE COUCHE ATOMIQUE REDOX

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**04.12.2019 Bulletin 2019/49**

(73) Proprietors:
• **IMEC vzw**
  **3001 Leuven (BE)**
• **Katholieke Universiteit Leuven**
  **KU Leuven Research & Development**
  **3000 Leuven (BE)**

(72) Inventors:
• **ZANKOWSKI, Stanislaw Piotr**
  **3001 Heverlee (BE)**
• **VAN HOECKE, Laurens**
  **3001 Leuven (BE)**

(74) Representative: **Winger**
  **Mouterij 16 bus 101**
  **3190 Boortmeerbeek (BE)**

(56) References cited:
**JP-A- H0 250 974     US-A1- 2016 090 652**

• YANLIN WU ET AL: "Atomic Layer Deposition from Dissolved Precursors", NANO LETTERS, vol. 15, no. 10, 29 September 2015 (2015-09-29), pages 6379-6385, XP055447798, US ISSN: 1530-6984, DOI: 10.1021/acs.nanolett.5b01424
• KAILASH VENKATRAMAN ET AL: "Electrochemical Atomic Layer Deposition of Copper: A Lead-Free Process Mediated by Surface-Limited Redox Replacement of Underpotentially Deposited Zinc", JOURNAL OF THE ELECTROCHEMICAL SOCIETY, vol. 163, no. 12, 6 May 2016 (2016-05-06), pages D3008-D3013, XP055528107, ISSN: 0013-4651, DOI: 10.1149/2.0021612jes

EP 3 575 004 B1

**Description**

**Technical field of the invention**

The present invention relates to a method for depositing an inorganic film on a substrate. In particular embodiments of the present invention relate to the deposition of a metal or metal oxide film on a substrate.

**Background of the invention**

Deposition of thin layers of materials is of a big interest to many industries, such as semiconductor, energy storage/conversion or coatings. One of the most attractive thin film deposition techniques called Atomic Layer Deposition (ALD) allows for control of the deposited layer thickness down to monolayer (~1Å) precision. This method is based on repetitive cycling of (in most cases) at least two chemical precursors in the vapor phase over a surface of interest. The precursors possess unique ability to react with chemically clean surfaces of defined composition (e.g. surfaces saturated with -OH terminations), while intrinsic reactions between molecules of the same precursor do not happen. A good overview of ALD technique can be found in the review article of George et al. (George, S. M. Atomic Layer Deposition: An Overview. Chem. Rev. 110, 111-131 (2010)). Very commonly, the ALD technique is used to deposit transition metal oxides, such as $Al_2O_3$, $HfO_2$, $TiO_2$, etc. which are classified as high-k dielectrics and are of especially important for CMOS processing. The first ALD precursor is a metalorganic compound MLx with a metal atom M, such as aluminum, bound to x number (e.g. 3) of organic ligands L such as methyl groups. An example of such precursor is trimethylaluminum (TMA) - $Al(CH_3)_3$, used for ALD deposition of $Al_2O_3$. In the first deposition step, the first precursor is pulsed into the reaction chamber, where it binds to the chemically clean surface of interest (e.g. surface saturated with -OH terminations. The binding happens by reaction of part ($1<n<x$) of the MLx precursor ligands with the surface groups, such as -OH. Due to the steric hindrance, only a part of the ligands L present in each MLx molecule is reacted with the surface at the first step, leaving some of the ligands still bound to the metal M. After removal of the excess of unreacted precursor 1, the second precursor, such as water vapor is introduced to the reaction environment. The second precursor reacts with unreacted ligands L bound to the metal M, resulting in hydrolysis and substitution of ligands L with hydroxyl groups OH. Thus, after reacting with the second precursor, the surface possesses a similar chemical composition (i.e. termination with -OH groups) as the initial surface prior to deposition. Upon removal of the excess of the second precursor, the cycle is completed.

Thanks to the surface-limited character of the reaction, the deposition happens in a layer-by-layer manner, usually with < 1Å growth rate per cycle. The final thickness of the deposit is precisely controlled by the number of applied cycles. The ALD technique offers excellent conformality of deposited layers over high aspect ratio and three-dimensional structures, such as nanotrenches, micropillars, nanowires, etc. The method offers much better deposit uniformity than commonly used CVD and PVD techniques, where shadowing effects are frequently observed.

The Atomic Layer Deposition is in most cases a gas-phase technique. The deposition happens at reduced pressure; the precursors are brought into the gas phase by evaporation or sublimation. The reason for that is to ensure good contact (provided by gas diffusion) between the precursor molecules and surfaces while limiting the total amount of the precursors present at each step in the reaction chamber (thus limiting the time needed for their removal between consecutive cycle steps). The complete removal of precursors between steps is essential to exclude bulk-scale, uncontrollable deposition which can happen due to the existence of leftover precursors on the surface of interest. The deposition is normally carried out at modestly elevated temperatures (<350°C), which are needed for sufficient rate of reaction and to avoid condensation of precursors at the surfaces of interest. The usually observed lower-than-monolayer ALD growth rate can be ascribed to the big molecular size of the metalorganic precursors, which usually require few cycles to fully complete the first layer of deposited material. The deposition requires sophisticated equipment, such as a vacuum chamber equipped with mass-flow controllers and electronic valves. The chamber walls and gas lines need to be heated and thermally isolated to avoid condensation of precursors. The metalorganic precursors are usually expensive, flammable and not stable in contact with air or water. Ignition of the precursors upon exposure to air has been frequently observed. Due to these factors, it is of great interest to find alternatives to gas phase thermal ALD process. Preferably, the process should show close-to-monolayer growth rates, use stable precursors and be doable at ambient conditions.

A liquid-phase variation of the Atomic Layer Deposition is known as Electrochemical Atomic Layer Deposition. This technique is described in Stickney, J. et al. (Semiconductors, Electrochemical Atomic Layer Deposition (E-ALD), Encyclopedia of Applied Electrochemistry eds. Kreysa, G., Ota, K. & Savinell, R. F., 1947-1952, Springer New York, 2014). This technique is based on so-called Underpotential Deposition (UPD) - self-limited deposition of a monolayer of an element from a solution containing ions of that element, after application of a specific electrical potential to the surface of interest. This method can be used to deposit thin layers of metals, such as copper or palladium, metal alloys, such as PtRu or transition metal chalcogenides (e.g. molybdenum diselenide or cadmium sulfide). As an example, an E-ALD cycle of CdS consists of four steps: UPD deposition of a monolayer of sulfur from an $S^{2-}$ solution, rinsing with

water, UPD deposition of a monolayer of cadmium from a $C^{d2+}$ solution, followed by a second rinsing step. In another variation of E-ALD, the deposition can be carried out from a solution containing so-called sacrificial ions (e.g. $Zn^{2+}$) and ions of the element (e.g. $Cu^{2+}$) to be deposited. The ALD cycle starts by UPD deposition of a sacrificial ions monolayer upon application of the specific electric potential to the surface of interest. This is followed by turning off the externally applied potential and subsequent chemical replacement reaction happening between the sacrificial metal and the metal to be deposited. In this case, the deposition is possible only when the reduction potential of the sacrificial metal is much lower than the reduction potential of the metal to be deposited. As an example, the E-ALD of copper, reported by Venkatraman et al. (Electrochemical Atomic Layer Deposition of Copper: A Lead-Free Process Mediated by Surface-Limited Redox Replacement of Underpotentially Deposited Zinc. J. Electrochem. Soc. 163, D3008-D3013 (2016)), can be performed from a dilute solution of copper sulfate and zinc sulfate, on a copper or ruthenium substrate. The E-ALD cycle consists of two steps: application of - 1.1 V vs. Ag/AgCl for 20s to the substrate, upon which UPD of Zn at the substrate surface is observed. This is followed by redox replacement of Zn by Cu at the open circuit potential, according to the equation:

$$Zn\ (UPD)+Cu^{2+}(aq)\leftrightarrow Cu + Zn^{2+}(aq)$$

The redox replacement is possible thanks to the sufficiently high difference between the reduction potential of zinc and copper. After certain stabilization time, the entire Zn monolayer is replaced with a copper monolayer and the cycle is completed.

The E-ALD method is currently limited only to conductive substrates. Prior to application, the method requires a complex electrochemical investigation for every ion pair to be employed in a deposition. The electrochemical window and specific potential of UPD strongly depend on the intrinsic reduction potentials of the ions, the concentration of ions in the solution, the presence of surfactants etc. The E-ALD method requires the use of a potentiostat in so-called 3-electrodes setup. Because of that, the uniformity of the deposit depends on the precise placement of the electrodes in the deposition cell. All these facts show the limited applicability of E-ALD for e.g. large-scale deposition of materials on industrially-relevant substrates such as 200 mm-diameter silicon wafers. It is thus of big interest to develop a simple ALD method which is applicable to a broad range of substrates, does not require the electrical hardware, nor the sophisticated setup. Also, it is of interest to develop a method based on simple surface-limited chemical reactions.

Another variation of liquid ALD was demonstrated for deposition of metal oxide films (e.g. $TiO_2$) from organic solutions of metal alkoxides, such as titanium isopropoxide (see Shen, Y. et al., Towards atomic level vanadium doping of TiO2 via liquid-phase atomic layer deposition. Appl. Catal. A Gen. 409-410, 87-90 (2011)). Here, the precursors bind to the substrate surface via hydrolysis reaction of alkoxide chains with the -OH groups present at the surface of the substrate, resulting in deposition of metal oxide films. This method, however, needs to be done in anhydrous solvents (e.g. toluene) and neutral atmosphere, in order to prevent bulk hydrolysis of metal alkoxide in the solution leading to the uncontrollable growth of the material. It is, therefore, of interest to develop a method which does not require the use of organic solvents (benefit for the environment) and does not require anhydrous conditions which are hard to implement.

JPH0250974A discloses a method to produce an insulating material having a selectively metallized surface. To that end, the surface is patterned in the form of roughened surface areas and smooth surface areas. A low molecular compound containing an N, P or O electron donating atom is then brought into contact with and selectively trapped by the rough part of the surface. Next, a catalytic metal compound for the electroless plating is brought into contact with the rough surface and adsorbs to the low molecular compound. After washing, the catalytic metal compound is reduced with a reducing agent. Finally, electroless plating is performed by exposing the surface to an electroless plating solution.

US2016090652A1 discloses a processing system and method for depositing a film on a substrate by liquid phase ALD. The method includes providing the substrate in a process chamber, spinning on the substrate a first reactant in a first liquid to form a self-limiting layer of the first reactant on the substrate, spinning on the substrate a second reactant in a second liquid, where the second reactant reacts with the self-limiting layer of the first reactant on the substrate to form a film on the substrate, and repeating the spinning steps at least once until the film has a desired thickness.

Wu et al. (WU, Yanlin, et al. Atomic layer deposition from dissolved precursors. Nano letters, 2015, 15.10: 6379-6385.) described a MgO sALD ("Solution ALD") procedure based on the hydrolysis of a Grignard reagent.

## Summary of the invention

It is an object of the present invention to provide good methods for depositing a layer of inorganic material on a substrate.

It is an advantage of embodiments of the present invention that they involve the use of liquids. Liquids are easier to handle than gases.

It is an advantage of embodiments of the present invention that they permit a growth rate close to one monolayer per cycle, hence allowing the deposition of a monolayer in fewer cycles than is typically required by gas-phase ALD and typically in a single cycle.

It is an advantage of embodiments of the present invention that the precursors involved (the organic compound and the inorganic ion or ion complex) are stable. In particular, they may be stable in contact with air. This permits working under atmospheric pressure in presence of air without the risk of air-induced ignition. Also advantageous is that they may be stable in contact with water. Working in anhydrous conditions is therefore not needed.

It is an advantage of embodiments of the present invention that the precursor involved (the organic compound and the inorganic ion or ion complex) are typically inexpensive.

It is an advantage of embodiments of the present invention that it can be performed at ambient temperature.

It is an advantage of embodiments of the present invention that no sophisticated equipment is needed. In particular, no vacuum chamber, mass flow controllers, heating elements, electronic valves, or electrodes are required.

It is an advantage of embodiments of the present invention that the deposition may be performed on a large variety of substrates, including dielectric, semiconductor or conductive substrates.

It is an advantage of embodiments of the present invention that it does not necessitate applying a potential to the substrate or to the solutions.

It is an advantage of embodiments of the present invention that it is conformal.

It is an advantage of embodiments of the present invention that it can be easily performed at a large scale.

It is an advantage of embodiments of the present invention that it is self-limiting, hence permitting an excellent control of the thickness.

It is an advantage of embodiments of the present invention that it does not require the use of organic solvents, which is beneficial for the environment.

The above objective is accomplished by a method and device according to the present invention.

The present invention relates to a method to deposit a layer of inorganic material on a substrate surface. The method comprises one or more cycles. Each cycle comprises a step a) followed by a step b). Step a) comprises contacting the substrate surface with a first aqueous liquid solution. The first aqueous liquid solution comprises an organic compound having a functional group permitting its adsorption on the substrate. Step b) comprises contacting the substrate surface having the organic compound adsorbed thereon with a second liquid aqueous solution. The second liquid aqueous solution comprises an inorganic ion or an ion complex suitable for oxidizing the organic compound and having an insoluble reduction product which is the inorganic material.

This new type of ALD process happens due to a redox reaction between an organic compound and an ion in the liquid phase. In this process, the ALD cycling is done by repetitively alternating contact of the surface of interest with two liquid aqueous solutions: solution A containing an organic compound showing monolayer attachment at the surface, and solution B of inorganic ions or ion complexes which act as an oxidizer towards the attached organic compound. The oxidation of the organic compound on the surface comes together with the reduction of the ions in solution B, forming a monolayer of the products of reduction of B. We can speak of an ALD process because the surface-limited reaction criterion of ALD is met by the surface-limited character of attachment of the organic compound.

The present invention provides a method to deposit a layer of inorganic material on a substrate surface, comprising one or more cycles, each cycle comprising the steps of:

a) contacting the substrate surface with a first aqueous liquid solution comprising an organic compound having a functional group permitting its adsorption on the substrate, followed by
b) contacting the substrate surface having the organic compound adsorbed thereon with a second liquid aqueous solution comprising an inorganic ion or an ion complex suitable for oxidizing the organic compound and having an insoluble reduction product which is the inorganic material, wherein each cycle deposits from 0.1 to 1.5 monolayer.

In embodiments, the inorganic material may be a metal or a metal oxide.

In embodiments, the metal may be selected from transition metals. In embodiments, the transition metal may be selected in group 10 or group 11 of the IUPAC periodic table (e.g. Au, Ag or Pt)

In embodiments, the metal oxide may be selected from transition metal oxides (e.g. oxides of Bh, Co, Cr, Cu, Db, Fe, Hf, Hs, Ir, Mn, Mo, Nb, Ni, Os, Pd, Re, Rf, Rh, Ru, Sc, Sg, Ta, Tc, Ti, V, W, Y, and Zr), post-transition metal oxides (oxides of Al, Zn, Cd, Hg, Po, Ga, In, Sn, Tl, Pb and Bi) and Se.

Preferably, the inorganic material is selected from transition metal oxides, oxides of Se, oxides of Tl, and oxides of Bi. More preferably, the inorganic material is selected from oxides of Cr, Ir, Mn, Pd, Re, Rh, Ru, Se, Tc, Tl, and Bi.

In embodiments, the transition metal oxide may be a Manganese oxide.

The manganese oxide may, for instance, be a mixture of different manganese oxides having oxidation states ranging from +2 to +4. For instance, the manganese oxide may comprise $MnO_2$ and $Mn_3O_4$.

The substrate may be any substrate. It is typically chosen so that it is not degraded by the aqueous liquid solution. It is also typically chosen so that the organic compound can adsorb thereon (either by chemisorption or physisorption). The surface of the substrate can be treated to facilitate that adsorption. For instance, it can be made hydrophilic.

Examples of suitable substrates are Metals and metal oxide substrates but any substrate would be suitable as long as the organic molecule can adsorb thereon. Examples of metal substrates are transition metals and post-transition metals. Ni, Zn, Pt, and Au are typical non-limitative examples of suitable metal substrates. Examples of metal oxide substrates are oxides of metalloids (B, Si, Ge, As, Sb, Te, and At), oxides of transition metals (e.g. $TiO_2$) and oxides of post-transition metals. $SiO_2$, $GeO_2$, $TiO_2$, and $Al_2O_3$ are typical non-limitative examples of suitable metal oxide substrates.

The method comprises one or more cycles. The number of cycles will depend on the desired thickness for the inorganic material.

According to the present invention, each cycle deposits from 0.1 to 1.5 monolayer, preferably from 0.5 to 1 monolayer.

The method involves contacting the substrate surface with a first liquid aqueous solution.

The first aqueous liquid solution is typically at room temperature (e.g. from 18 to 30 °C) but other temperatures can be used.

The first aqueous liquid solution is typically at atmospheric pressure but other pressures can be used.

The first aqueous liquid solution comprises the organic compound.

In embodiments, the concentration of the organic compound in the solution may be from $10^{-6}$ M to 1M, for instance from 0.01 to 0.5M or from 0.05M to 0.5M.

The organic compound is selected in such a way that it can adsorb on the chosen substrate. For this purpose, it typically has one or more functional groups suitable for permitting the adsorption of the molecule on the substrate.

In embodiments, the organic compound may, for instance, comprise one or more functional groups selected from the list consisting of unsaturated carbons, alcohol, carboxylic acid, ester, aldehydes, amine, and thiol.

Unsaturated carbons (E.g. carbon atoms bound by double bonds (including in aromatic groups), or triple bonds) are known to adsorb on metals such as Ni and on metalloids oxide substrates such as $SiO_2$. Examples of organic compounds comprising unsaturated carbons are unsaturated alcohols such as allyl alcohol or propargyl alcohol; unsaturated hydrocarbons such as limonene, 5-methyl-3-undecene, and citronellal; aromatics such as phenol, benzoic acid, benzyl alcohol, diethyl phthalate or dibutyl phthalate.

Alcohols are known to adsorb on metal (e.g. on Ni) in alkaline conditions (pH>7) and in neutral pH on metalloids oxide substrates such as $SiO_2$. Examples of alcohols are $C_{1-20}$ alcohols such as methanol, ethanol, 1-propanol, isopropanol, 1-butanol, isooctanol, 2-ethylhexanol, and the likes.

Esters, aldehydes and carboxylic acids are known to adsorb on metalloid oxides substrates such as $SiO_2$. Examples of esters are C1-20 esters such as diethyl phthalate, dibutyl phthalate, 2,2,4-trimethyl-1,3-pentanediol diisobutyrate, dodecanoic acid propyl ester, and acetic acid 1-methoxyethyl ester, and the likes. Examples of aldehydes are C1-20 aldehydes such as citronellal and the likes. Examples of carboxylic acids are C1-20 carboxylic acids such as benzoic acid, adipic acid, and the likes.

Thiols are known to adsorb on metals such as gold. Examples of thiols are C1-20 thiols such as 1-decanethiol, 1-propanethiol and the likes.

Amines are known to adsorb on a large variety of substrates. Examples of amines are C1-20 amines such as propylamine, butylamine, and the likes.

Naturally, compounds exhibiting a combination of functionalities can also exhibit adsorption, possibly stronger adsorption, on various solid substrates. For example, propargyl alcohol having both unsaturated carbon bonds (aryl group) and alcohol group is believed to show stronger adsorption on nickel than, for example, ethanol, having only an alcohol functional group.

In embodiments, the first aqueous liquid solution is an alkaline solution of an organic alcohol and wherein the substrate is selected so that it does not degrade in the alkaline solution.

Step b) of the method comprises contacting the substrate having the organic compound adsorbed thereon with a second liquid aqueous solution comprising an inorganic ion or an ion complex suitable for oxidizing the organic compound and having an insoluble reduction product (in the mixture of the first and second aqueous liquid solution) which is the inorganic material.

The second aqueous liquid solution is typically at room temperature (e.g. from 18 to 30 °C) but other temperatures can be used.

The second aqueous liquid solution is typically at atmospheric pressure but other pressures can be used.

Typically, the method is performed at room temperature.

Typically, the method is performed at atmospheric pressure.

In embodiments, the steps a) and b) of contacting the substrate with an aqueous solution may be performed by immersing the substrate in the aqueous solution. However, other methods can of course be used.

Typically, neither step a) nor step b) is performed electrochemically, i.e. no external potential is applied.

The inorganic ion or an ion complex is suitable for oxidizing the organic compound. Preferably, it has a reduction potential more positive than the reduction potential of the organic compound.

In embodiments, the inorganic ion or ion complex may be an ion or ion complex of a transition metal, a post-transition metal oxides or Se.

Preferably, the inorganic ion or ion complex may be selected from ions or ion complexes of a transition metal, Se, Tl, and Bi. In embodiments, the inorganic ion or ion complex may be selected from $Ag^+$, $AuCl_4^-$, $Cr_2O_7^{2-}$, $CrO_4^{2-}$, $[IrCl_6]^{2-}$, $[IrCl_6]^{3-}$, $MnO_4^-$, $Pd^{2+}$, $[PdCl_4]^{2-}$, $[PtCl_4]^{2-}$, $[PtCl_6]^{2-}$, $ReO_4^-$, $Rh^+$, $Rh^{3+}$, $[RhCl_6]^{3-}$, $Ru^{2+}$, $SeO_3^{2-}$, $Tc^{3+}$, $TcO_4^-$, $Tl^{3+}$, and $Bi^+$.

In embodiments, the method may be conformal.

In embodiments, each cycle further comprises an aqueous rinsing step a') after step a) and before step b), and an aqueous rinsing step b') after step b) and before any subsequent cycle. The aqueous rinsing steps are preferably performed with demineralized water.

Particular and preferred aspects of the invention are set out in the accompanying independent and dependent claims. Features from the dependent claims may be combined with features of the independent claims and with features of other dependent claims as appropriate and not merely as explicitly set out in the claims.

Although there has been constant improvement, change and evolution of methods in this field, the present concepts are believed to represent substantial new and novel improvements, including departures from prior practices, resulting in the provision of more efficient, stable and reliable methods of this nature.

The above and other characteristics, features and advantages of the present invention will become apparent from the following detailed description, taken in conjunction with the accompanying drawings, which illustrate, by way of example, the principles of the invention. This description is given for the sake of example only, without limiting the scope of the invention. The reference figures quoted below refer to the attached drawings.

**Brief description of the drawings**

Fig. 1 is a schematic representation of a redox ALD cycle of $MnO_x$ according to an embodiment of the present invention.

Fig. 2 are linear scan voltammograms in $LiClO_4$/propylene carbonate electrolyte plotting the current density (Id) versus the potential (V) vs $Li/Li^+$ of $MnO_x$ layers deposited on a Ni substrate for a different number of cycles according to an embodiment of the present invention. The voltammograms were recorded at 10 mV/s.

Fig. 3 is a graph of the $MnO_x$ reduction Charge (Q) as a function of the number of cycles according to an embodiment of the present invention.

Fig. 4 are cyclic voltammograms of nickel electrodes coated with MnOx for a different number of deposition cycles, performed in 0.5 M $Na_2SO_4$ at 20 mV/s according to an embodiment of the present invention.

Fig. 5 is a graph of the cathodic charges derived from the CV on Ni substrate, as a function of a number of MnOx deposition cycles according to an embodiment of the present invention.

Fig. 6 is a graph of the thickness of MnOx layers deposited on $TiO_2$ according to an embodiment of the present invention, as determined with RBS.

Fig. 7 is a graph of the thickness of MnOx layers deposited on Pt according to an embodiment of the present invention, as determined with RBS.

Fig. 8 is a bar plot of the thickness of MnOx layers deposited after 10 deposition cycles on Pt, Si, $SiO_2$ and $TiO_2$ substrates according to embodiments of the present invention, as determined with RBS.

Fig. 9 shows Cyclic Voltammograms of nickel substrates after 10 cycles of deposition of MnOx layers using 0.1M Propargyl alcohol (PA) (embodiment) or alkaline 0.1M Isopropyl alcohol (IPA) (embodiment) as the organic adsorptives. Also, deposition without an alcohol (comparative) is shown for comparison. The voltammograms were recorded in 0.5M $Na_2SO_4$ at 20 mV/s.

**Description of illustrative embodiments**

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

Furthermore, the terms first, second, third and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly, it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

In the description provided herein, numerous specific details are set forth. However, it is understood that embodiments of the invention may be practiced without these specific details. In other instances, well-known methods, structures and techniques have not been shown in detail in order not to obscure an understanding of this description.

The invention will now be described by a detailed description of several embodiments of the invention. It is clear that other embodiments of the invention can be configured according to the knowledge of persons skilled in the art without departing from the technical teaching of the invention, the invention being limited only by the terms of the appended claims.

Example 1: Deposition of $MnO_x$ on Ni using propargyl alcohol as the organic compound.

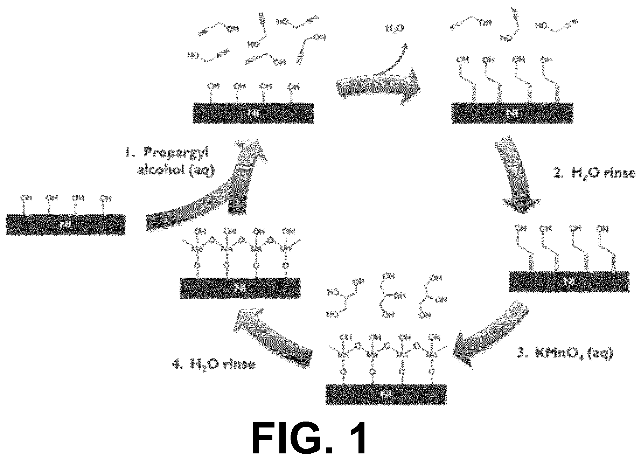

The deposition of $MnO_x$ on Ni is schematically given in Fig. 1. The Ni surface was immersed for 1 min in a 0.1M solution of propargyl alcohol. During this time, the alcohol strongly adsorbed at the surface of interest. Without being bound by theory, it is believed that the strong adsorption happens due to the presence of unsaturated pi-bonding in the organic molecule, resulting in strong interactions between the molecule and the surface. In Fig. 1, the chemisorption of propargyl alcohol is assumed, as represented by the formation of allyl alcohol bound to the surface. After the time of immersion, the sample was taken out and washed with copious amount of water. After washing with water, a monolayer of adsorbed alcohol was present on the Ni surface. After that, the sample was immersed in a 0.1M solution of potassium permanganate at pH ~7 for 1 min. During this time, a chemical reaction between surface-adsorbed alcohol molecules and $MnO_4^-$ ions occurs, resulting in oxidation of propargyl alcohol and reduction of $MnO_4^-$ to a mixture of different manganese oxides with manganese oxidation states ranging from +2 to +4 as determined by X-ray Photoemission Spectroscopy (XPS). In particular, the formation of $MnO_2$ (having manganese at +4 oxidation state) and $Mn_3O_4$ (having two Mn atoms at +3 oxidation state and one Mn atom at +2 oxidation state) is observed. $MnO_2$ is the major species and the phase expected from the general mechanism of reduction of MnO4- anions in a neutral pH according to half-reaction reaction: $MnO_4^- + 3e- + 4H_3O^+ \leftrightarrow MnO_2 + 6H_2O$.

Since chemisorption is assumed (as represented in Fig. 1), and the pH was ~7, the reaction leading to the formation of $MnO_2$ could be written as the oxidation of allyl alcohol to glycerol:

$$\text{Allyl alcohol} + 2 \text{ OH-} \leftrightarrow \text{glycerol} + 2 \text{ e}^-$$

Thus, the total reaction can be written as:

$$2 MnO_4^- + 2 H_3O^+ + 3 C_3H_6O \leftrightarrow 2 MnO_2 + 3 C_3H_8O_3$$

The amount of deposited $MnO_2$ is limited to a monolayer by the monolayer amount of the alcohol present at the surface.

Example 2a: determination of the growth per cycle in Example 1 by CV in $LiClO_4$/proplyle carbonate as the electrolyte.

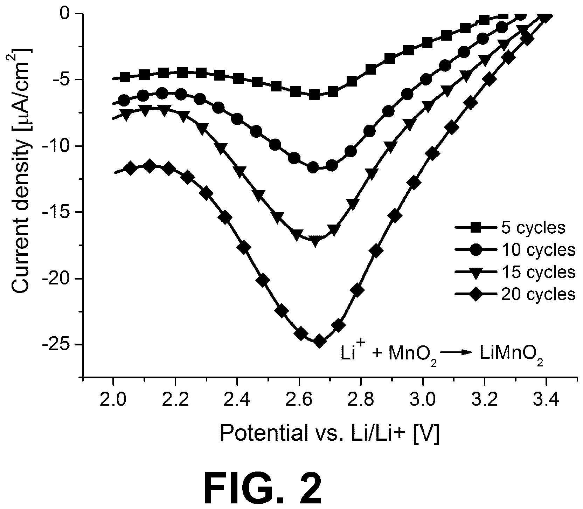

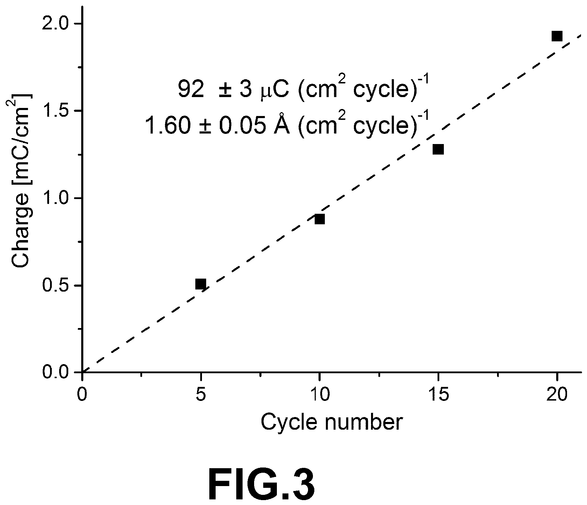

The growth per cycle was determined using cyclic voltammetry of deposited $MnO_x$ layers in 1M $LiClO_4$ in propylene carbonate. For this determination, the growth rate was determined assuming $MnO_2$ as the structure of $MnO_x$. The results are presented in Figs. 2 and 3 where the determination of growth per cycle of $MnO_2$ using Li+ insertion is performed. In Fig.2, Cyclic Voltammograms of $MnO_2$ layers (in $LiClO_4$/propylene carbonate electrolyte) deposited on the nickel substrate for a different number of ALD cycles is shown. The area of the $MnO_2$ reduction peak increased with the increasing number of cycles. In Fig. 3, the dependency of the $MnO_2$ reduction charge on the number of ALD cycles was studied.

The thickness of the $MnO_2$ was proportional to the electrical charge Q passed during insertion of the Li+ into the material upon cathodic scan to 2V vs Li/Li+. The growth per cycle can be determined according to Farraday's law:

$$\text{Growth rate of } MnO_x \text{ per cycle} = [(Q'*Mw)/(d*F*n)] \ [\text{Å cm}^{-2} \text{ cycle}^{-1}] \ (1)$$

where Q' is the linear slope of the dependency: reduction charge (derived from the CV) vs. number of deposition cycles;
where F is the Farraday's constant (96485 C/mol),
n is the number of electrons associated with the reduction reaction (n=1 if $MnO_2$ is assumed as the deposited layer; n would be equal to 2 if $Mn_3O_4$ was assumed as the deposited layer);
Mw is the molar mass of the manganese oxide species (86,94 g/mol for $MnO_2$ and 228,81 g/mol for $Mn_3O_4$); and
d is the volumetric mass of the manganese oxide species (5,03 g/cm$^3$ for $MnO_2$ and 4,86 g/cm$^3$ for $Mn_3O_4$).

When $MnO_2$ was assumed, The slope of $92\pm3$ $\mu$C (cm$^2$ cycle)$^{-1}$ of the fitted function represents the experimentally determined growth per cycle of $1.60\pm0.05$ Å/cycle, which is close to the theoretical limit of 1.9Å/cycle and 8x the growth-per-cycle of conventional thermal ALD of $MnO_2$.

Example 2b: determination of the growth per cycle in Example 1 by CV in $Na_2SO_4$ as the electrolyte.

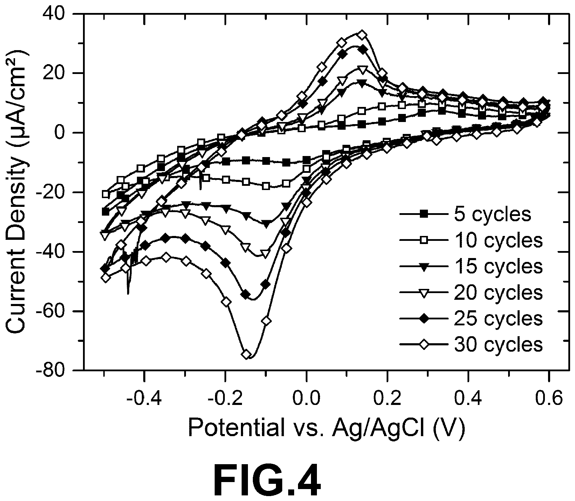

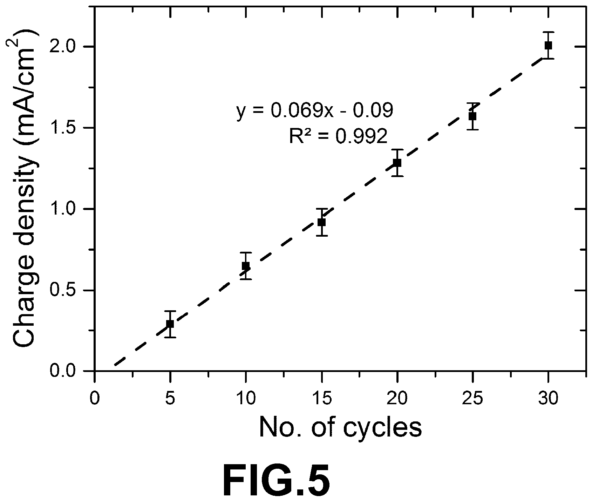

Example 2 was repeated in 0.5 M $Na_2SO_4$ as the electrolyte. Fig. 4 shows the voltammograms of Ni wafers coated with MnOx after different amount of deposition cycles, recorded in 0.5 M $Na_2SO_4$, at the scan rate of 20 mV/s. The reducive peak at -0.13 V vs. Ag/AgCl is seen to increase with the number of depositions and thus can be associated with the reduction of manganese oxide layers present at the nickel surface. The charge associated with this reduction, derived from the voltammograms, was found to linearly increase with increasing number of MnOx deposition cycles (Fig. 5). This charge was found to increase with a slope Q'of 69 $\mu$C (cm$^2$ cycle)$^{-1}$. Using Equation (1), the growth rate was thus calculated as $1.24 \pm 0.07$ Å cm$^{-2}$ cycle$^{-1}$ for $MnO_2$, or $1.68 \pm 0.09$ Å cm$^{-2}$ cycle$^{-1}$ for $Mn_3O_4$. It is noteworthy that in both cases, the growth rate is close, yet inferior to the theoretical thickness of a monolayer (1.88 Å for $MnO_2$ and 2.08 Å for $Mn_3O_4$, as derived from the average Mn - O bond lengths in both materials). The sub-monolayer growth rate is a requirement for the process to be considered as an Atomic Layer Deposition.

Example 3: Deposition of $MnO_x$ on $TiO_2$.

Example 1 was repeated by substituting a $TiO_2$ surface for the Ni surface.

Example 4: Deposition of $MnO_x$ on Pt.

Example 1 was repeated by substituting a Pt surface for the Ni surface.

Example 5: Deposition of $MnO_x$ on Si.

Example 1 was repeated by substituting a Si surface for the Ni surface.

Example 6: Deposition of $MnO_x$ on $SiO_2$.

Example 1 was repeated by substituting a $SiO_2$ surface for the Ni surface.

Example 7: determination of the growth per cycle in Examples 3 and 4.

Rutherford Backscattering Spectroscopy (RBS) was used by assuming a particular structure of MnOx ($MnO_2$ or $Mn_3O_4$). The growth rate of MnOx was investigated by performing increasing number of depositions and analyzing by RBS the incremental manganese signal present on each sample.

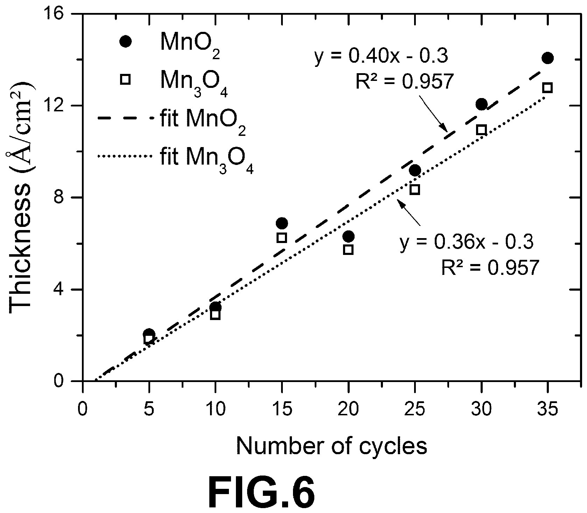

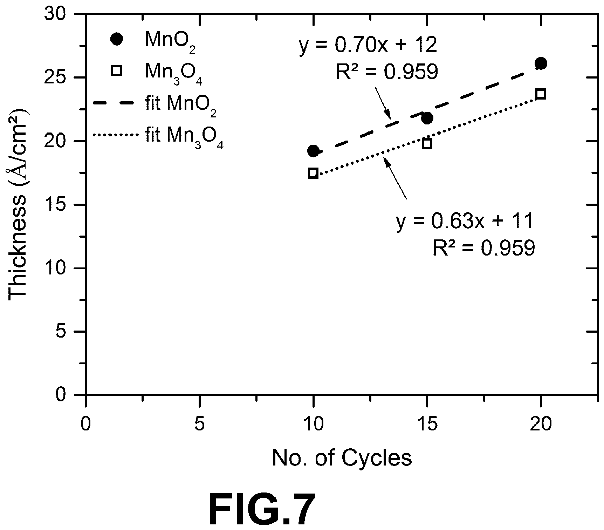

For $TiO_2$ (Example 3) and Pt (Example 4), RBS experiments were performed on the samples after up to 20 cycles of deposition (Pt) and up to 35 cycles of deposition ($TiO_2$), In this case, the areal concentration of manganese atoms was derived from the measurements and converted to the thickness of manganese oxide, using the density and molar mass of $MnO_2$ or $Mn_3O_4$. The results are presented in Fig. 6 and 7.

For $TiO_2$, the results indicate the growth rate of 0.4 Å cm$^{-2}$ cycle$^{-1}$ ($MnO_2$) and 0.36 Å cm$^{-2}$ cycle$^{-1}$ ($Mn_3O_4$). For the Pt substrate, the growth rate was found as 0.7 Å cm$^{-2}$ cycle$^{-1}$ ($MnO_2$) and 0.63 Å cm$^{-2}$ cycle$^{-1}$ ($Mn_3O_4$).

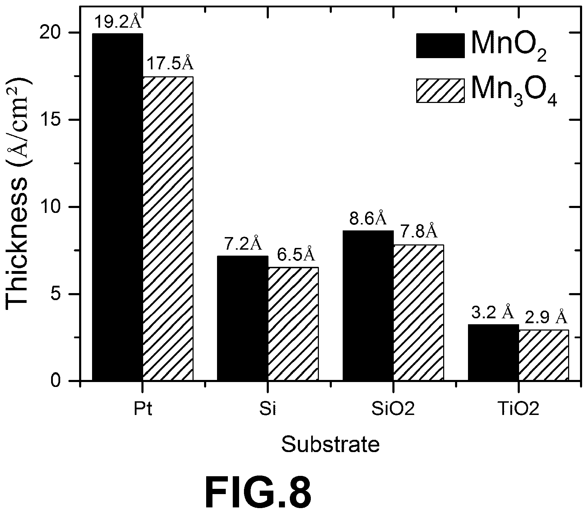

In further experiment, the amount of manganese oxide deposited after 10 cycles was analyzed with RBS on Si (Example 5) and $SiO_2$ (Example 6) substrates, and compared to the amount determined on $TiO_2$ and Pt (Fig. 8).

The amount of MnOx present at the surface was found to be the highest for Pt substrate (17.5 - 19.2 Å cm$^{-2}$), followed by $SiO_2$ (7.8 - 8.6 Å cm$^{-2}$), Si (6.5 - 7.2 Å cm$^{-2}$) and $TiO_2$ (2.9 - 3.2 Å cm$^{-2}$). The different amounts of the material present on different substrates after 10 cycles could be ascribed to the different strength of adsorption of the propargyl alcohol to the bare substrates - thus the amount of initial reduction of $MnO_4^-$ at the surface is also different. Nevertheless, the growth rate on Pt and $TiO_2$ was found to be linearly dependent on the number of deposition cycles (Fig. 6 and 7). It is noteworthy that the substrate-dependent growth rate is also known for the conventional thermal ALD of metal oxides.

Example 8: determination of the growth per cycle in Examples 5 and 6.

Although a cycle per cycle growth rate was not analyzed on Si and $SiO_2$, the presence of MnOx at these surfaces was confirmed by RBS after 10 deposition cycles. If normalized to the number of deposition cycles, growth rates of - 0.7 Å cm$^{-2}$ cycle$^{-1}$ and ~0.8 Å cm$^{-2}$ cycle$^{-1}$ could be inferred for the Si and $SiO_2$ substrates, respectively.

Example 9: Deposition of MnOx on Ni substrate using isopropyl alcohol as the organic compound (embodiment) or not using any organic compound (comparative)

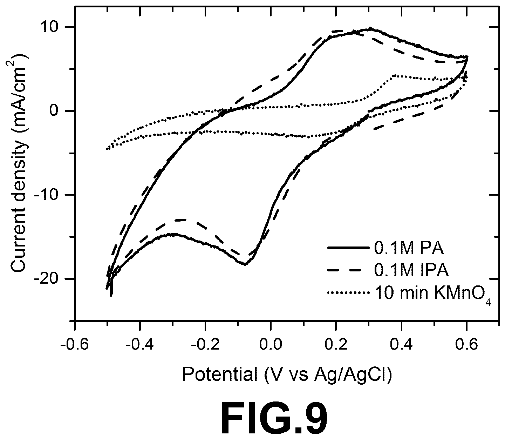

In an experiment, the deposition of MnOx on Ni substrate was attempted using an alkaline solution of 0.1M isopropyl alcohol. The results were compared with that when 0.1M propargyl alcohol was used (Example 1), as well as when no alcohol was used during the deposition and the substrate was simply held in 0.1M $KMnO_4$ solution for 10 min. Cyclic Voltammetry was performed to detect the presence of MnOx layer. The results are shown in Fig. 9.

The deposition was successful with both the 0.1M Propargyl alcohol and the alkaline 0.1M isopropanol solutions used as the organic adsorptives, as indicated by the presence of the cathodic peak at - -0.1 V vs. Ag/AgCl. No deposition occurred when no alcohol was used, as indicated by the lack of cathodic peak for the sample which was immersed for 10 min in 0.1M $KMnO_4$ solution.

This indicates that the adsorption of the organic molecule is the key for successful MnOx deposition. It is believed that the deprotonated alcohol, such as the alkaline isopropanol, is able to adsorb on the surface of a metal, allowing for the subsequent deposition of MnOx.

It is to be understood that although preferred embodiments, specific constructions and configurations, as well as materials, have been discussed herein for devices according to the present invention, various changes or modifications in form and detail may be made without departing from the scope of this invention as defined in the appended claims.

For example, any formulas given above are merely representative of procedures that may be used. Functionality may be added or deleted from the block diagrams and operations may be interchanged among functional blocks. Steps may be added or deleted to methods described within the scope of the present invention.

**Claims**

1. Method to deposit a layer of inorganic material on a substrate surface, comprising one or more cycles, each cycle comprising the steps of:

   a) contacting the substrate surface with a first aqueous liquid solution comprising an organic compound having a functional group permitting its adsorption on the substrate, followed by
   b) contacting the substrate surface having the organic compound adsorbed thereon with a second liquid aqueous solution comprising an inorganic ion or an ion complex suitable for oxidizing the organic compound and having an insoluble reduction product which is the inorganic material; and wherein each cycle deposits from 0.1 to 1.5 monolayer.

2. The method according to claim 1, wherein the ion or ion complex has a reduction potential more positive than the reduction potential of the organic compound.

3. The method according to any of the preceding claims, wherein the steps a) and b) of contacting the substrate with an aqueous solution are performed by immersing the substrate in the aqueous solution.

4. The method according to any of the preceding claims, performed at room temperature.

5. The method according to any of the preceding claims, performed at atmospheric pressure.

6. The method according to any one of the preceding claims, wherein the inorganic ion or ion complex is selected from Ag , $AuCl_4^-$, $Cr_2O_7^-$, $CrO_4^-$, $[IrCl_6]^{2-}$, $[IrCl_6]^{3-}$, $MnO_4^-$, $Pd^{2+}$, $[PdCl_4]^{2-}$, $[PtCl_4]^{2-}$, $[PtCl_6]^{2-}$, $ReO^{4-}$, $Rh^+$, $Rh^{3+}$, $[RhCl_6]^{3-}$, $Ru^{2+}$, $SeO_3^-$, $Tc^{3+}$, $TcO_4^-$, $Tl^{3+}$, and $Bi^+$.

7. The method according to any of the preceding claims, wherein the inorganic material is a metal or a metal oxide.

8. The method according to claim 7, wherein the metal oxide is a transition metal oxide.

9. The method according to claim 8, wherein the transition metal oxide is a Manganese oxide.

10. The method according to any of the preceding claims, wherein neither step a) nor step b) is performed electrochemically.

11. The method according to any one of the preceding claims, being conformal.

12. The method according to any one of the preceding claims, wherein each cycle further comprises an aqueous rinsing step a') after step a) and before step b), and an aqueous rinsing step b') after step b) and before any subsequent cycle.

13. The method according to any one of claims 1 to 12, wherein the organic compound comprises one or more functional groups selected from the list consisting of unsaturated carbons, alcohol, carboxylic acid, ester, aldehyde, amine, and thiol.

14. The method according to claim 13, wherein the first aqueous liquid solution is an alkaline solution of an organic alcohol and wherein the substrate is selected so that it does not degrade in the alkaline solution.

**Patentansprüche**

1. Verfahren zur Abscheidung einer Schicht aus anorganischem Material auf einer Substratoberfläche, umfassend einen oder mehrere Zyklen, wobei jeder Zyklus die folgenden Schritte umfasst:

   a)- Inkontaktbringen der Substratoberfläche mit einer ersten wässrigen flüssigen Lösung, die eine organische Verbindung umfasst, die eine funktionelle Gruppe aufweist, die ihre Adsorption auf dem Substrat zulässt, gefolgt von
   b)- Inkontaktbringen der Substratoberfläche, auf der die organische Verbindung adsorbiert ist, mit einer zweiten flüssigen wässrigen Lösung, die ein anorganisches Ion oder einen Ionenkomplex umfasst, der zur Oxidation der organischen Verbindung geeignet ist und ein unlösliches Reduktionsprodukt aufweist, welches das anorganische Material ist; und wobei jeder Zyklus 0,1 bis 1,5 Monoschichten abscheidet.

2. Das Verfahren nach Anspruch 1, wobei das Ion oder der Ionenkomplex ein positiveres Reduktionspotential aufweist als das Reduktionspotential der organischen Verbindung.

3. Das Verfahren nach einem der vorstehenden Ansprüche, wobei die Schritte a) und b) des Inkontaktbringens des Substrats mit einer wässrigen Lösung durch Eintauchen des Substrats in die wässrige Lösung durchgeführt werden.

4. Das Verfahren nach einem der vorstehenden Ansprüche, das bei Raumtemperatur durchgeführt wird.

**5.** Das Verfahren nach einem der vorstehenden Ansprüche, das bei Atmosphärendruck durchgeführt wird.

**6.** Das Verfahren nach einem der vorstehenden Ansprüche, wobei das anorganische Ion oder der Ionenkomplex ausgewählt ist aus $Ag^+$, $AuCl_4^-$, $Cr_2O_7^-$, $CrO_4^-$, $[IrCl_6]^{2-}$, $[IrCl_6]^{3-}$, $MnO_4^-$, $Pd^{2+}$, $[PdCl_4]^{2-}$, $[Ptcl_4]^{2-}$, $[Ptcl_6]^{2-}$, $ReO_4^-$, $Rh^+$, $Rh^{3+}$, $[RhCl_6]^{3-}$, $Ru^{2+}$, $SeO_3^-$, $Tc^{3+}$, $TcO_4^-$, $Tl3^+$ und $Bi^+$.

**7.** Das Verfahren nach einem der vorstehenden Ansprüche, wobei das anorganische Material ein Metall oder ein Metalloxid ist.

**8.** Das Verfahren nach Anspruch 7, wobei das Metalloxid ein Übergangsmetalloxid ist.

**9.** Das Verfahren nach Anspruch 8, wobei das Übergangsmetalloxid ein Manganoxid ist.

**10.** Das Verfahren nach einem der vorstehenden Ansprüche, wobei weder Schritt a) noch Schritt b) elektrochemisch durchgeführt wird.

**11.** Verfahren nach einem der vorstehenden Ansprüche, wobei es konform ist.

**12.** Das Verfahren nach einem der vorstehenden Ansprüche, wobei jeder Zyklus weiter einen wässrigen Spülschritt a') nach Schritt a) und vor Schritt b) und einen wässrigen Spülschritt b') nach Schritt b) und vor jedem nachfolgenden Zyklus umfasst.

**13.** Das Verfahren nach einem der Ansprüche 1 bis 12, wobei die organische Verbindung eine oder mehrere funktionelle Gruppen umfasst, die aus der Liste ausgewählt sind, die aus ungesättigten Kohlenstoffen, Alkohol, Carbonsäure, Ester, Aldehyd, Amin und Thiol besteht.

**14.** Das Verfahren nach Anspruch 13, wobei die erste wässrige flüssige Lösung eine alkalische Lösung eines organischen Alkohols ist und wobei das Substrat so ausgewählt ist, dass es in der alkalischen Lösung nicht abgebaut wird.

## Revendications

**1.** Procédé pour déposer une couche de matériau inorganique sur une surface de substrat, comprenant un ou plusieurs cycles, chaque cycle comprenant les étapes de :

a) Mise en contact de la surface de substrat avec une première solution aqueuse liquide comprenant un composé organique ayant un groupe fonctionnel permettant son adsorption sur le substrat, suivie de
b) Mise en contact de la surface de substrat ayant le composé organique adsorbé sur celle-ci avec une deuxième solution aqueuse liquide comprenant un ion inorganique ou un complexe ionique approprié pour oxyder le composé organique et ayant un produit de réduction insoluble qui est le matériau inorganique ; et dans laquelle chaque cycle dépose de 0,1 à 1,5 monocouche.

**2.** Le procédé selon la revendication 1, dans lequel l'ion ou le complexe ionique a un potentiel de réduction plus positif que le potentiel de réduction du composé organique.

**3.** Le procédé selon l'une quelconque des revendications précédentes, dans lesquelles les étapes a) et b) de mise en contact du substrat avec une solution aqueuse sont effectuées par immersion du substrat dans la solution aqueuse.

**4.** Le procédé selon l'une quelconque des revendications précédentes, effectué à température ambiante.

**5.** Le procédé selon l'une quelconque des revendications précédentes, effectué à la pression atmosphérique.

**6.** Le procédé selon l'une quelconque des revendications précédentes, dans lequel l'ion inorganique ou le complexe ionique est sélectionné parmi $Ag^+$, $AuCl_4^-$, $Cr_2O_7^-$, $CrO_4^-$, $[IrCl_6]^{2-}$, $[IrCl_6]^{3-}$, $MnO_4^-$, $Pd^{2+}$, $[PdCl_4]^{2-}$, $[PtCl_4]^{2-}$, $[PtCl_6]^{2-}$, $ReO_4^-$, $Rh^+$, $Rh^{3+}$, $[RhCl_6]^{3-}$, $Ru^{2+}$, $SeO_3^-$, $Tc^{3+}$, $TcO_4^-$, $Ti^{3+}$, et $Bi_+$.

**7.** Le procédé selon l'une quelconque des revendications précédentes, dans lequel le matériau inorganique est un métal ou un oxyde métallique.

**8.** Le procédé selon la revendication 7, dans lequel l'oxyde métallique est un oxyde de métal de transition.

**9.** Le procédé selon la revendication 8, dans lequel l'oxyde de métal de transition est un oxyde de manganèse.

**10.** Le procédé selon l'une quelconque des revendications précédentes, dans lequel ni l'étape a) ni l'étape b) n'est effectuée électrochimiquement.

**11.** Le procédé selon l'une quelconque des revendications précédentes, étant conforme.

**12.** Le procédé selon l'une quelconque des revendications précédentes, dans lequel chaque cycle comprend en outre une étape de rinçage aqueux a') après l'étape a) et avant l'étape b), et une étape de rinçage aqueux b') après l'étape b) et avant tout cycle subséquent.

**13.** Le procédé selon l'une quelconque des revendications 1 à 12, dans lequel le composé organique comprend un ou plusieurs groupes fonctionnels sélectionnés dans la liste constituée de carbones insaturés, d'alcool, d'acide carboxylique, d'ester, d'aldéhyde, d'amine, et de thiol.

**14.** Le procédé selon la revendication 13, dans lequel la première solution aqueuse liquide est une solution alcaline d'un alcool organique et dans lequel le substrat est sélectionné de telle sorte qu'il ne se dégrade pas dans la solution alcaline.

FIG. 1

FIG. 2

FIG.3

**FIG.4**

FIG.5

**FIG.6**

**FIG.7**

FIG.8

FIG.9

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP H0250974 A

- US 2016090652 A1

**Non-patent literature cited in the description**

- **GEORGE, S. M.** Atomic Layer Deposition: An Overview. *Chem. Rev.,* 2010, vol. 110, 111-131
- Semiconductors, Electrochemical Atomic Layer Deposition (E-ALD). **STICKNEY, J. et al.** Encyclopedia of Applied Electrochemistry. Springer, 2014, 1947-1952
- **VENKATRAMAN et al.** Electrochemical Atomic Layer Deposition of Copper: A Lead-Free Process Mediated by Surface-Limited Redox Replacement of Underpotentially Deposited Zinc. *J. Electrochem. Soc.,* 2016, vol. 163, D3008-D3013

- **SHEN, Y. et al.** Towards atomic level vanadium doping of TiO2 via liquid-phase atomic layer deposition. *Appl. Catal. A Gen.,* 2011, vol. 409-410, 87-90
- **WU, YANLIN et al.** Atomic layer deposition from dissolved precursors. *Nano letters,* 2015, vol. 15.10, 6379-6385